# EUROPEAN PATENT APPLICATION

(11) **EP 2 161 739 A1**
(43) Date of publication of application: **10.03.2010**
(21) Application number: 07860422.0
(22) Date of filing: 27.12.2007
(51) Int. Cl.: H01L 21/52, C09J 7/00, C09J 11/06, C09J 133/00, C09J 163/00, H01L 25/065, H01L 25/07, H01L 25/18

(54) **ADHESIVE FILM AND SEMICONDUCTOR DEVICE OBTAINED WITH THE SAME**

(30) Priority: 22.06.2007 JP 2007165604
(71) Applicant: Sumitomo Bakelite Company Limited, Shinagawa-ku Tokyo 140-0002 (JP)
(72) Inventor: YOSHIDA, Masato, Tokyo 140-0002 (JP)
(74) Representative: Solf, Alexander
(86) International application number: PCT/JP2007/075201
(87) International publication number: WO 2009/001492

(57) **Abstract**

The adhesive film of the present invention is adapted to be used for bonding a semiconductor element and a substrate together or bonding semiconductor elements together. The adhesive film is formed of a resin composition containing an epoxy resin, an acrylic resin, and an acrylic oligomer having a weight average molecular weight of 6,000 or less. The resin composition is **characterized in that** in the case where an amount of the acrylic resin contained in the resin composition is defined as Wa and an amount of the acrylic oligomer contained therein is defined as Wb, a ratio of Wa/Wb is in the range of 0.5 to 4. Further, the semiconductor device of the present invention is **characterized in that** a semiconductor element and a substrate or semiconductor elements are bonded together using the above mentioned adhesive film.

## Description

### TECHNICAL FIELD

The present invention relates to an adhesive film and a semiconductor device having the same.

### BACKGROUND ART

Recently, a semiconductor package in which semiconductor elements are mounted on a substrate at a high density is widely used according to miniaturizing and thinning of electronic devices.
Generally, such a semiconductor package is manufactured through a bonding step of bonding the semiconductor element and the substrate together through an adhesive film, a wire bonding step of electrically connecting the semiconductor element and the substrate together, and a sealing step of sealing the semiconductor element with a sealing resin (see, e.g., patent document 1 : Japanese Patent Application Laid-open No. 2003-60127).

Here, it is required that the adhesive film to be used in such a semiconductor package has a function of bonding the semiconductor element and the substrate together and a function of filling irregularities of the substrate. A conventional adhesive film is softened by heating and compressing in the sealing step so that the irregularities of the substrate can be filled therewith.

However, in a recent semiconductor package, a plurality of semiconductor elements are mounted in a multistep manner on a substrate at a high density. In order to mount the semiconductor elements in the multistep manner, a time required for the wire bonding step becomes long.
Therefore, there is a case that the adhesive film cannot be softened sufficiently in the sealing step due to excessive curing thereof so that irregularities of the substrate cannot be filled therewith.

### DISCLOSURE OF THE INVENTION

It is an object of the present invention to provide an adhesive film which can be softened by heating in a bonding step and has an improved filling property (initial filling property) for irregularities of a substrate, and a semiconductor device having the above adhesive film.

In order to achieve the object, the present invention includes the following features (1) to (16):
(1) An adhesive film being adapted to be used for bonding a semiconductor element and a substrate together or bonding semiconductor elements together, the adhesive film being formed of a resin composition, the resin composition comprising: an epoxy resin; an acrylic resin; and an acrylic oligomer having a weight average molecular weight of 6,000 or less, wherein in the case where an amount of the acrylic resin contained in the resin composition is defined as Wa and an amount of the acrylic oligomer contained therein is defined as Wb, a ratio of Wa/Wb is in the range of 0.5 to 4.
(2) The adhesive film according to the above feature (1), wherein a glass transition temperature of the acrylic oligomer is -30°C or lower.
(3) The adhesive film according to the above feature (1) or (2), wherein the amount of the acrylic oligomer with respect to a total amount of the resin composition is in the range of 5 to 30 wt%.
(4) The adhesive film according to any one of the above features (1) to (3), wherein the acrylic oligomer includes at least one of a carboxyl group and a glycidyl group.
(5) The adhesive film according to any one of the above features (1) to (4), wherein the acrylic oligomer is in the form of liquid at room temperature.
(6) The adhesive film according to any one of the above features (1) to (5), wherein the resin composition further comprises a curing agent.
(7) The adhesive film according to the above feature (6), wherein the curing agent includes a liquid phenol compound.
(8) The adhesive film according to any one of the above features (1) to (7), wherein the resin composition further comprises a curing catalyst.
(9) The adhesive film according to the above feature (8), wherein the curing catalyst includes an imidazole compound.
(10) The adhesive film according to the above feature (8) or (9), wherein a melting point of the curing catalyst is 150°C or higher.
(11) The adhesive film according to any one of the above features (1) to (10), wherein a melting viscosity at 100°C of the adhesive film is 80 Pa·s or less.
(12) The adhesive film according to any one of the above features (1) to (11), wherein elastic modulus at 175°C of a cured product, which is obtained by subjecting the adhesive film to a heat treatment at 175°C for 2 hours, is 30 MPa or more.
(13) An adhesive film being adapted to be used as an adhesive layer included in a semiconductor device, the semiconductor device in which a first semiconductor element having a functional surface, the adhesive layer and a second semiconductor element are laminated together on a side of one surface of a substrate in this order, wherein terminals formed on the functional surface of the first semiconductor element are electrically connected to the one surface of the substrate via bonding wires, a portion of each of the bonding wires near the terminals passing through the adhesive layer, the adhesive film being formed of a resin composition, the resin composition comprising: an epoxy resin; an acrylic resin; and an acrylic oligomer having a weight average molecular weight of 6,000 or less, wherein in the case where an amount of the acrylic resin contained in the resin composition is defined as Wa and an amount of the acrylic oligomer contained therein is defined as Wb, a ratio of Wa/Wb is in the range of 0.5 to 4.
(14) The adhesive film according to the above feature (13), wherein an area in a planar view of the second semiconductor element is substantially equal to that of the first semiconductor element.
(15) The adhesive film according to the above feature (13), wherein an area in a planar view of the second semiconductor element is lager than that of the first semiconductor element.
(16) A semiconductor device in which a semiconductor element and a substrate or semiconductor elements are bonded together using the above adhesive film according to any one of the above features (1) to (15).

### BRIEF DESCRIPTION OF THE DRAWINGS

FIG. 1 is a view schematically showing a bonding adhesive state of an adhesive film.
FIG. 2 is a flow diagram showing one example of a manufacturing method of a semiconductor device.
FIG. 3 is a view schematically showing one example of the semiconductor device.
FIG. 4 is a view schematically showing one example of the semiconductor device.

### BEST MODE FOR CARRYING OUT THE INVENTION

Hereinafter, an adhesive film and a semiconductor device of the present invention will be described.
The adhesive film of the present invention is an adhesive film being adapted to be used for bonding a semiconductor element and a substrate together or bonding semiconductor elements together and is formed of a resin composition including an epoxy resin, an acrylic resin, and an acrylic oligomer having a weight average molecular weight of 6,000 or less.
The resin composition is **characterized in that** in the case where an amount of the acrylic resin contained in the resin composition is defined as Wa and an amount of the acrylic oligomer contained therein is defined as Wb, a ratio of Wa/Wb is in the range of 0.5 to 4.
Further, the semiconductor device of the present invention is **characterized in that** a semiconductor element and a substrate or semiconductor elements are bonded together using the above mentioned adhesive film.

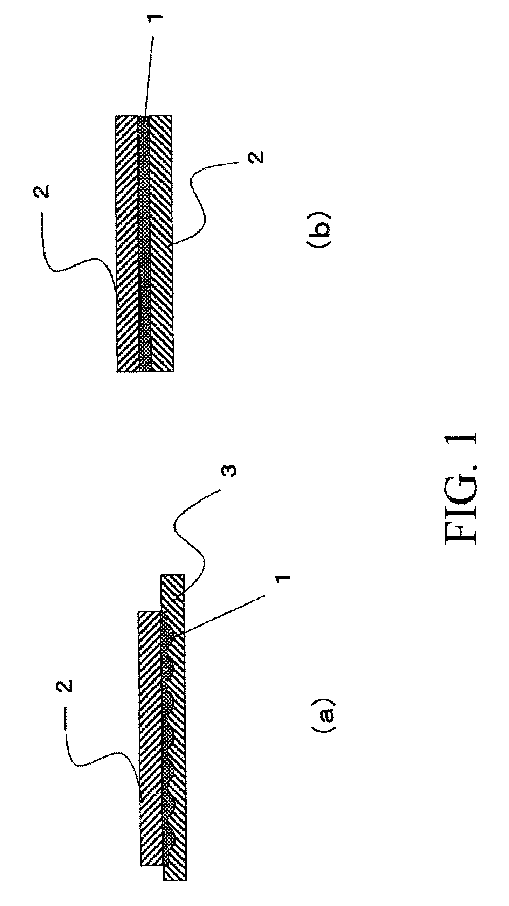

First, the adhesive film will be described.
As shown in FIG.1, an adhesive film 1 is used for (a) bonding of a semiconductor element 2 and a substrate 3 or (b) bonding of a semiconductor element 2 and a semiconductor element 2.
The adhesive film 1 is formed of the resin composition including the epoxy resin, the acrylic resin and the acrylic oligomer having the weight average molecular weight of 6,000 or less. This makes it possible for the adhesive film 1 to have a filling property for irregularities of the substrate 3, and heat resistance and adhesion in an excellent balance.

The resin composition includes the epoxy resin. This makes it possible to impart the heat resistance and adhesion to the adhesive film 1.
Examples of the epoxy resin include: a bisphenol type epoxy resin such as bisphenol A type epoxy resin and bisphenol F type epoxy resin; a novolac type epoxy resin such as novolac epoxy resin and cresol novolac epoxy resin; a biphenyl type epoxy resin; a stilbene type epoxy resin; a triphenol methane type epoxy resin; an alkyl-denatured triphenol methane type epoxy resin; a triazine chemical structure-containing epoxy resin; a dicyclopentadiene-denatured phenol type epoxy resin; and the like, and these resins may be used independently or in combination.
Among these resins, the novolac type epoxy resin is preferable. This makes it possible to further improve the heat resistance and adhesion of the adhesive film 1.

An amount of the epoxy resin contained in the resin composition is not particularly limited to a specific value, but the amount of the epoxy resin with respect to a total amount of the resin composition is preferably in the range of 30 to 60 wt%, and more preferably in the range of 40 to 50 wt%.
If the amount of the epoxy resin is smaller than the lower limit value, there is a case that the filling property of the adhesive film 1 for the irregularities of the substrate 3 is lowered in a bonding step. On the other hand, if the amount of the epoxy resin exceeds the upper limit value, there is a case that an effect for improving a film forming ability of the adhesive film 1 is lowered.

The resin composition also includes the acrylic resin. This makes it possible to improve a film forming ability of the adhesive film 1.
The acrylic resin includes polymers of acrylic acid and derivatives thereof. Specifically, examples of the acrylic resin include homopolymers of acrylic acid, methacrylic acid, an acrylate such as methyl acrylate and ethyl acrylate, a methacrylate such as methyl methacrylate and ethyl methacrylate, acrylic nitrile, acryl amide and the like, copolymers of there monomers and other monomers, and the like.
Further, among these acrylic resins, an acrylic resin (an acrylate copolymer) including compounds (comonomer components) each having an epoxy group, a hydroxyl group, a carboxyl group, a nitrile group or the like is preferable. This makes it possible to further improve the adhesion of the adhesive film 1 to an adherend such as the semiconductor element 2.
Specifically, examples of the compound having the above functional group include glycidyl methacrylate having a glycidyl ether group, hydroxy methacrylate having a hydroxyl group, carboxy methacrylate having a carboxyl group, acrylonitrile having a nitrile group and the like.

A weight average molecular weight of the acrylic resin is not particularly limited to a specific value, but is preferably 100,000 or more, and more preferably in the range of 150,000 to 1,000,000.
In the case where the weight average molecular weight of the acrylic resin is within the above range, it is possible to especially improve a film forming ability of the adhesive film 1. In addition, in the case where the weight average molecular weight of the acrylic resin is within the above range, even if the acrylic resin includes a thermosetting functional group, it is impossible for the acrylic resin itself to exhibit a thermosetting behavior.
For example, the weight average molecular weight can be measured using a gel permeation chromatography (GPC). The gel permeation chromatography is carried out, for example, using a high speed GPC apparatus ("SC-8020", produced by Tosoh Corporation) and a column ("TSK-GEL GMHXL-L" , produced by Tosoh Corporation) under a measuring condition in which a temperature is 40°C and a solvent is tetrahydrofuran.

An amount of the acrylic resin contained in the resin composition is not particularly limited to a specific value, but the amount of the epoxy resin with respect to the total amount of the resin composition is preferably in the range of 5 to 30 wt%, and more preferably in the range of 8 to 20 wt%.
If the amount of the acrylic resin is smaller than the lower limit value, there is a case that a film forming ability of the adhesive film 1 is lowered. On the other hand, if the amount of the acrylic resin exceeds the upper limit value, there is a case that the filling property of the adhesive film 1 for the irregularities of the substrate 3 is lowered in the bonding step.

The resin composition also includes the acrylic oligomer.
Examples of the acrylic oligomer include homopolymeric oligomers of acrylic acid, methacrylic acid, an acrylate such as methyl acrylate and ethyl acrylate, a methacrylate such as methyl methacrylate and ethyl methacrylate, acrylic nitrile, acryl amide and the like, copolymeric oligomers of there monomers and other monomers, and the like.
Further, among these acrylic oligomers, an acrylic oligomer including compounds (comonomer components) each having an epoxy group, a hydroxyl group, a carboxyl group, a nitrile group or the like is preferable, and an acrylic oligomer including at least one of a carboxyl group and a glycidyl group is especially preferable. This makes it possible to further improve adhesion of the adhesive film 1 to an adherend such as the semiconductor element.
Specifically, examples of the compound having the above functional group include glycidyl methacrylate having a glycidyl ether group, hydroxy methacrylate having a hydroxyl group, carboxy methacrylate having a carboxyl group, acrylonitrile having a nitrile group and the like.
Further, these oligomers may be in the form of liquid or solid at room temperature.

The weight average molecular weight of the acrylic oligomer is 6,000 or less. This makes it possible to improve the initial filling property of the adhesive film 1.
Specifically, the weight average molecular weight of the acrylic oligomer is preferably 4,500 or less, and more preferably in the range of 1,500 to 3,000.
If the weight average molecular weight of the acrylic oligomer is lower than the lower limit value, there is a case that an effect for improving a film forming ability of the adhesive film 1 is lowered. On the other hand, if the weight average molecular weight of the acrylic oligomer exceeds the upper limit value, there is a case that the filling property of the adhesive film 1 for the irregularities of the substrate 3 is lowered in the bonding step.
For example, the weight average molecular weight can be measured using a gel permeation chromatography (GPC) . The gel permeation chromatography is carried out, for example, using a high speed GPC apparatus ("SC-8020", produced by Tosoh Corporation) and a column ("TSK-GEL GMHXL-L", produced by Tosoh Corporation) under a measuring condition in which a temperature is 40°C and a solvent is tetrahydrofuran.

In the case where the weight average molecular weight of the acrylic resin is defined as Mw1 and the weight average molecular weight of the acrylic oligomer is defined as Mw2, a ratio of Mw1/ Mw2 is not particularly limited to a specific value, but is preferably 20 or more, and more preferably 60 or more.
If the ratio of the weight average molecular weights is lower than the lower limit value, there are cases that an effect for improving a film forming ability of the adhesive film 1 is lowered and that an effect for improving the heat resistance of the adhesive film 1 is also lowered.

A glass transition temperature of the acrylic oligomer is not particularly limited to a specific value, but is preferably -30°C or lower, and more preferably in the range of -50 to -35°C.
In the case where the glass transition temperature of the acrylic oligomer is within the above range, a tack property of the adhesive film 1 becomes large, as a result of which it can have excellent initial adhesion to an adherend.
Tensile strength is measured by pulling the adhesive film 1 under constant load (10 mN) using a thermomechanical analyser ("TMA/SS6100", produced by Seiko Instruments Inc.) while rising a temperature at a heating speed of 5°C/min from -65°C, and the glass transition temperature can be determined based on a value in an inflection point of the tensile strength.

The amount of the acrylic oligomer contained in the resin composition is not particularly limited to a specific value, but the amount of the acrylic oligomer with respect to the total amount of the resin composition is preferably in the range of 5 to 30 wt%, and more preferably in the range of 10 to 20 wt%.
If the amount of the acrylic oligomer is smaller than the lower limit value, there is a case that a film forming ability of the adhesive film 1 is lowered. If the amount of the acrylic oligomer exceeds the upper limit value, there is a case that the filling property of the adhesive film 1 for the irregularities of the substrate 3 is lowered in the bonding step.

The resin composition is **characterized in that** the ratio (Wa/Wb) of the amount Wa of the acrylic resin contained in the resin composition and the amount Wb of the acrylic oligomer contained therein is in the range of 0.5 to 4. In this case, the adhesive film 1 can exhibit the excellent initial filling property when being bonded to the substrate 3 and a superior film property.
Specifically, the ratio (Wa/Wb) of the amount Wa of the acrylic resin contained in the resin composition and the amount Wb of the acrylic oligomer contained therein is preferably in the range of 0.6 to 2, and more preferably in the range of 0.7 to 1.5.
If the ratio (Wa/Wb) of the amounts is lower than the lower limit value, there is a case that a film forming ability of the adhesive film 1 is lowered. On the other hand, if the ratio (Wa/Wb) of the amounts exceeds the upper limit value, there is a case that the filling property of the adhesive film 1 for the irregularities of the substrate 3 is lowered in the bonding step.

It is preferred that the resin composition further includes a curing agent, if needed.
Examples of the curing agent include: an amine based curing agent such as aliphatic polyamine (e.g., diethylene triamine (DETA), triethylene tetramine (TETA), meta-xylylene diamine (MXDA) and the like), aromatic polyamine (e.g., diamino diphenyl methane (DDM), m-phenylene diamine (MPDA), diamino diphenyl sulfone (DDS) and the like), dicyandiamide (DICY), and a polyamine compound containing organic acid dihydrazide; an acid anhydride based curing agent such as alicyclic acid anhydride (liquid acid anhydride) (e.g., hexahydro phthalic anhydride (HHPA), methyl tetrahydro phthalic anhydride (MTHPA) and the like), aromatic acid anhydride (e.g., trimellitic anhydride (TMA), pyromellitic anhydride (PMDA), benzophenone tetracarboxylic acid (BTDA) and the like); and a phenol based curing agent such as phenol resin. Among them, the phenol based curing agent (especially, a phenol compound being in the form of liquid at room temperature) is preferable.
Specifically, examples of the phenol based curing agent include bisphenols such as bis(4-hydroxy-3,5-dimethyl phenyl) methane (commonly known as tetramethyl bisphenol F), 4,4'-sulfonyl diphenol, 4,4'-isopropylidene diphenol (commonly known as bisphenol A), bis (4-hydroxy phenyl) methane, bis(2-hydroxy phenyl) methane, (2-hydroxy phenyl) (4-hydroxy phenyl) methane, and a mixture of 3 kinds of them, that is, a mixture of the bis (4-hydroxy phenyl) methane, the bis (2-hydroxy phenyl) methane and the (2-hydroxy phenyl) (4-hydroxy phenyl) methane (e.g., bisphenol F-D", produced by HONSHU CHEMICAL INDUSTRY CO. LTD.) ; dihydroxy benzenes such as 1, 2-benzenediol, 1,3-benzenediol and 1,4-benzenediol; trihydroxy benzenes such as 1,2,4-benzenetriol; various kinds of isomers of dihydroxy naphthalenes such as 1,6-dihydroxy naphthalene; various kinds of isomers of biphenols such as 2,2'-biphenol and 4,4'-biphenol; and the like.

An amount of the curing agent contained in the resin composition is not particularly limited to a specific value, but the amount of the curing agent with respect to the total amount of the resin composition is preferably in the range of 15 to 40 wt%, and more preferably in the range of 20 to 35 wt%.
If the amount of the curing agent is smaller than the lower limit value, there is a case that an effect for improving the heat resistance of the adhesive film 1 is lowered. On the other hand, if the amount of the curing agent exceeds the upper limit value, there is a case that storage stability of the adhesive film 1 is lowered.
In this regard, it is to be noted that the phenol resin is used as the phenol based curing agent, an amount of the phenol resin contained in the resin composition is calculated as not being the thermosetting resin.

It is also preferred that the resin composition further includes a curing catalyst, if needed. This makes it possible to improve a curing property of the adhesive film 1.
Examples of the curing catalyst include: an amine based catalyst such as imidazoles and 1,8-diazabicyclo(5,4,0)undecene; a phosphorous based catalyst such as triphenyl phosphine; and the like. Among them, the imidazoles are preferable. This makes it possible for the adhesive film 1 to appropriately have both a fast curing property and storage stability.
Examples of the imidazoles include: 1-benzyl-2-methyl imidazole; 1-benzyl-2-phenyl imidazole; 1-cyanoethyl-2-ethyl-4-methyl imidazole; 2-phenyl-4-methyl imidazole; 1-cyanoethyl-2-phenyl imidazolium trimellitate; 2,4-diamino-6-[2'-methyl imidazolyl-(1')]-ethyl-s-triazine; 2,4-diamino-6-[2'-undecyl imidazolyl-(1')]-ethyl-s-triazine; 2,4-diamino-6-[2'-ethyl-4'-methyl imidazolyl-(1')]-ethyl-s-triazine; 2,4-diamino-6-[2'-methyl imidazolyl-(1')]-ethyl-s-triazine isocyanuric acid adduct; 2-phenyl imidazole isocyanuric acid adduct; 2-phenyl-4,5-dihydroxy methyl imidazole; 2-phenyl-4-methyl-5-hydroxy methyl imidazole; 2,4-diamino-6-vinyl-s-triazine; 2,4-diamino-6-vinyl-s-triazine isocyanuric acid adduct; 2,4-diamino-6-methacryloyloxy ethyl-s-triazine; 2,4-diamino-6-methacryloyloxy ethyl-s-triazine isocyanuric acid adduct; and the like.
Among them, the 2-phenyl-4,5-dihydroxy methyl imidazole or the 2-phenyl-4-methyl-5-hydroxy methyl imidazole is preferable. This makes it possible to especially improve the storage stability of the adhesive film 1.

A melting point of the curing catalyst is not particularly limited to a specific value, but is preferably 150°C or higher, and more preferably in the range of 160 to 230°C. In the case where the melting point of the curing catalyst is within the above range, it is possible for the adhesive film 1 to have the filling property for the irregularities of the substrate 3 in the bonding step and the curing property in an excellent balance.
Examples of the curing catalyst having the melting point of 150°C or higher include the 2-phenyl-4,5-dihydroxy methyl imidazole, the 2-phenyl-4-methyl-5-hydroxy methyl imidazole and the like.

An amount of the curing catalyst contained in the resin composition is not particularly limited to a specific value, but the amount of the curing catalyst with respect to 100 parts by weight of the thermosetting resin is preferably in the range of 0.01 to 30 parts by weight, and more preferably in the range of 0.5 to 10 parts by weight.
If the amount of the curing catalyst is smaller than the lower limit value, there is a case that the curing property of the adhesive film 1 becomes insufficient. On the other hand, if the amount of the curing catalyst exceeds the upper limit value, there is a case that storage stability of the adhesive film 1 is lowered.

It is also preferred that the resin composition further includes a coupling agent, if needed. This makes it possible to further improve adhesion between the adhesive film 1 and an adherend and adhesion in a resin interface.
Examples of the coupling agent include a silane based coupling agent, a titanium based coupling agent, an aluminium based coupling agent and the like. Among them, the silane based coupling agent is preferable. This makes it possible to improve the heat resistance of the adhesive film 1.

Examples of the silane based coupling agent include: vinyl trichlorosilane; vinyl trimethoxy silane; vinyl triethoxy silane; β-(3,4-epoxy cyclohexyl) ethyl trimethoxy silane; γ-glycidoxy propyl trimethoxy silane; γ-glycidoxy propyl methyl dimethoxy silane; γ-methacryloxy propyl trimethoxy silane; γ-methacryloxy propyl methyl diethoxy silane, γ-methacryloxy propyl triethoxy silane; N-β(amino ethyl) γ-amino propyl methyl dimethoxy silane; N-β(amino ethyl) γ-amino propyl trimethoxy silane; N-β(amino ethyl) γ-amino propyl triethoxy silane; γ-amino propyl trimethoxy silane; γ-amino propyl triethoxy silane; N-phenyl-γ-amino propyl trimethoxy silane; γ-chloropropyl trimethoxy silane; γ-mercapto propyl trimethoxy silane; 3-isocyanate propyl triethoxy silane; 3-acryloxy propyl triethoxy silane; 3-acryloxy propyl trimethoxy silane; and the like.

An amount of the coupling agent contained in the resin composition is not particularly limited to a specific value, but the amount of the coupling agent with respect to 100 parts by weight of the thermosetting resin is preferably in the range of 0. 01 to 10 parts by weight, and more preferably in the range of 0.5 to 8 parts by weight.
If the amount of the coupling agent is smaller than the lower limit value, there is a case that an effect for improving the adhesion of the adhesive film 1 to an adherend is not exhibited sufficiently. If the amount of the coupling agent exceeds the upper limit value, there is a case that this causes occurrence of outgas from the adhesive film 1 or generation of voids therewithin.

The resin composition may contain an additive agent such as a leveling agent or an antifoaming agent, in addition to the epoxy resin, the acrylic resin, the acrylic oligomer, the curing agent and the like.

The adhesive film 1 can be obtained by dissolving such a resin composition into a solvent such as methyl ethyl ketone, acetone, toluene or dimethyl formaldehyde to form a varnish, applying the varnish onto a carrier film using a comma coater, a die coater, a gravure coater or the like, and then drying the same.
A thickness of the adhesive film 1 is not particularly limited to a specific value, but is preferably in the range of 3 to 100 µm, and more preferably in the range of 5 to 70 µm. In the case where the thickness of the adhesive film 1 is within the above range, it is possible to control thickness accuracy of the adhesive film 1 especially easily.

In the meanwhile, a melting viscosity at 100°C of the adhesive film 1 obtained in this way is not particularly limited to a specific value, but is preferably 80 Pa·s or less, and more preferably in the range of 45 to 75 Pa·s. In the case where the melting viscosity of the adhesive film 1 is within the above range, the adhesive film 1 can have the especially excellent filling property for the irregularities of the substrate 3.
The above mentioned melting viscosity can be measured by applying a film-shaped sample to a shear force having a frequency of 1 Hz while rising a temperature at a heating speed of 10°C/min using a rheometer which is a viscoelasticity measuring apparatus.

Further, elastic modulus at 175°C of a cured product, which is obtained by subjecting the adhesive film 1 to a heat treatment at 175°C for 2 hours, is not particularly limited to a specific value, but is preferably 30 MPa or more, and more preferably 40 MPa or more. In the case where the elastic modulus of the cured product of the adhesive film 1 is within the above range, it is possible to prevent breakage, crack or the like of the semiconductor device 2 from occurring by an inorganic filler in a sealing step.
For example, the above mentioned elastic modulus can be measured using a dynamic viscoelasticity measuring apparatus (DMA) under a condition in which a heating speed is 3°C/min and a frequency is 10 Hz.

Next, the semiconductor device will be described.

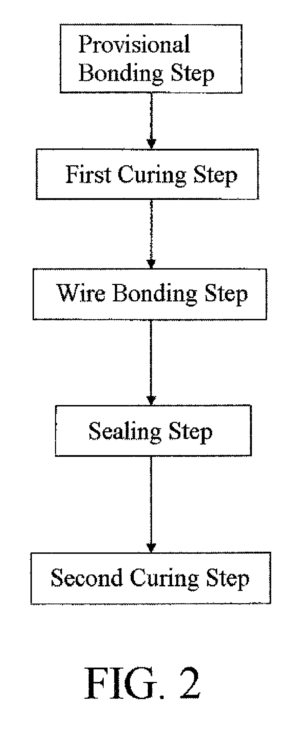

FIG. 2 is a flow diagram showing one example of a manufacturing method of the semiconductor device.
As shown in FIG. 2, the semiconductor device is manufactured through a provisional bonding step of provisionally bonding a substrate and a semiconductor element together through the adhesive film 1; a first curing step of curing the adhesive film 1 provisionally bonded so as to become a predetermined hardness; a wire bonding step of electrically connecting the semiconductor element to the substrate via bonding wires; a sealing step of sealing the semiconductor element and the bonding wires; and a second curing step of finally curing the adhesive film 1.

Hereinafter, each of steps will be easily described.

### (Provisional Bonding Step)

In the provisional bonding step, the semiconductor element and the substrate are provisionally bonded together through the adhesive film 1 to obtain a provisional bonded body. In this provisional bonding step, irregularities of the substrate are filled with the adhesive film 1, that is, an initial filling is carried out.
Specifically, the provisional bonding is carried out by laminating the substrate, the adhesive film 1 and the semiconductor element together in this order, and then heating and compressing the same by hot press. Here, the adhesive film 1 may have been, in advance, bonded to either the semiconductor element or the substrate.

### (First Curing Step)

In the first curing step, the provisional bonded body is subjected to a heat treatment or the like so that the resin composition constituting the adhesive film 1 is provisionally cured so as to become the predetermined hardness. By doing so, it is possible to improve bonding strength of the bonding wires in the wire bonding step.
Specifically, for example, the predetermined hardness is defined by a state that heat generation has been completed up to 50 to 80% of a total curing heat value of the adhesive film 1 which is measured using a differential calory meter.
Further, elastic modulus at 175°C of the adhesive film 1 passed through the first curing step is not particularly limited to a specific value, but is preferably 5.0 MPa or more, and more preferably in the range of 6.0 to 8.0 MPa. This makes it possible to improve the initial filling property of the adhesive film 1.

### (Wire Bonding Step)

In the wire bonding step, terminals of the semiconductor element and terminals of the substrate are electrically connected together via the bonding wires. For example, this connection by the bonding wires can be carried out using EAGLE (produced by ASM) or the like.
Here, the wire bonding step is carried out, in general, at a temperature of 150 to 250°C. Therefore, in the case where the adhesive film 1 has an excellent initial filling property, it tends to have low elastic modulus. In this case, the adhesive film 1 serves as a cushion to thereby reduce bonding strength of the bonding wires.
This is likely to lead to occurrence of disconnection thereof. For this reason, it is preferred that in the above mentioned first curing step, the hardness of the adhesive film 1 is increased up to a certain degree.
In this regard, the elastic modulus of the adhesive film 1 at a temperature when the wire bonding is carried out (e.g., 175°C) is not particularly limited to a specific value, but is preferably 5.0 MPa or more, and more preferably in the range of 6.0 to 8. 0 MPa. This makes it possible to improve the initial filling property of the adhesive film 1.

### (Sealing Step)

In the sealing step, the semiconductor element and the bonding wires via which the terminals of the semiconductor element and the terminals of the substrate are connected together are covered with a sealing resin to thereby seal the same. This makes it possible to protect the semiconductor element and to improve insulation and dampproof of the semiconductor device.
For example, the sealing step is carried out using a transfer molding machine under a sealing condition in which a sealing temperature is a high temperature of 150 to 200°C and a sealing pressure is a high pressure of 50 to 100 kg/mm².
If the semiconductor element and the substrate are bonded together (or in the case of laminating a plurality of semiconductor elements together, the semiconductor elements are bonded together) using a conventional adhesive agent, a filler contained in the sealing resin to be used in the sealing step penetrates into the conventional adhesive agent so that defects such as breakage, crack and the like are likely to occur in the semiconductor device(s).
After reviewing about this cause, the present inventor has found that since the adhesive agent (corresponding to the adhesive film 1 in this embodiment) is softened and compressed in the sealing step, the filler becomes easy to penetrate into the adhesive agent.
In the meanwhile, in the present invention, it is preferred elastic modulus at the sealing temperature of the adhesive film 1 through which the semiconductor element and the substrate or the semiconductor elements are bonded together is 6 MPa or more. In this case, since the adhesive agent can have a certain degree of hardness at the sealing temperature, it is possible to prevent the filler from penetrating thereinto.
Specifically, the elastic modulus at the sealing temperature is preferably 12 MPa or higher, and more preferably in the range of 8 to 50 MPa. For example, such an elastic modulus can be measured using a dynamic viscoelasticity measuring apparatus (DMA).
For example, the elastic modulus is defined by storage modulus obtained by measuring viscoelasticity using a dynamic viscoelasticity measuring apparatus produced by Seiko Instruments Inc. under a condition in which a heating speed is 3°C/min and a frequency is 10 Hz.

### (Second Curing Step)

In the second curing step, the sealing resin is cured and the adhesive film 1 is mainly cured so as to have hardness higher than the above hardness. In this way, it is possible to finally obtain the semiconductor device.
A condition in the second curing step is not particularly limited to a specific condition as long as the sealing resin can be cured and the curing of the adhesive film 1 can be stimulated, but is preferably a condition of 100 to 160°C × 5 to 180 minutes, and more preferably a condition of 120 to 130°C × 10 to 100 minutes.

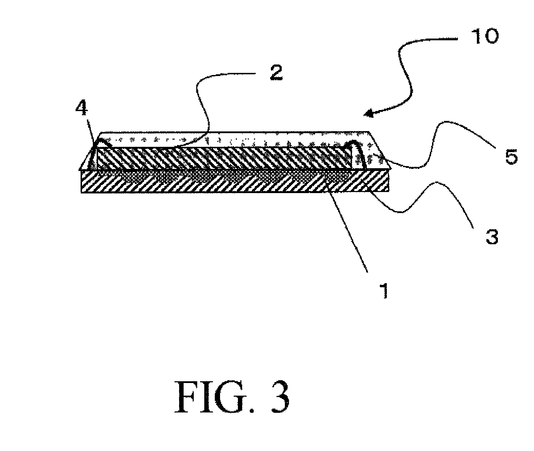

Through these steps, it is possible to finally obtain a semiconductor device 10 as shown in FIG. 3. In the semiconductor device 10, a semiconductor element 2 and a substrate 3 are bonded together through the adhesive film 1.
The semiconductor element 2 and the substrate 3 are electrically connected together via bonding wires 4. The semiconductor element 2 and the bonding wires 4 are covered (sealed) with a sealing resin 5.
In this regard, it is to be noted that the semiconductor device 10 obtained in the present invention may not be manufactured through the above steps, but may be manufactured through steps including no first curing step.
Since the adhesive film 1 having an excellent filling property for irregularities of the substrate 3 is used, the semiconductor device 10 of the present invention can have especially superior connection reliability.

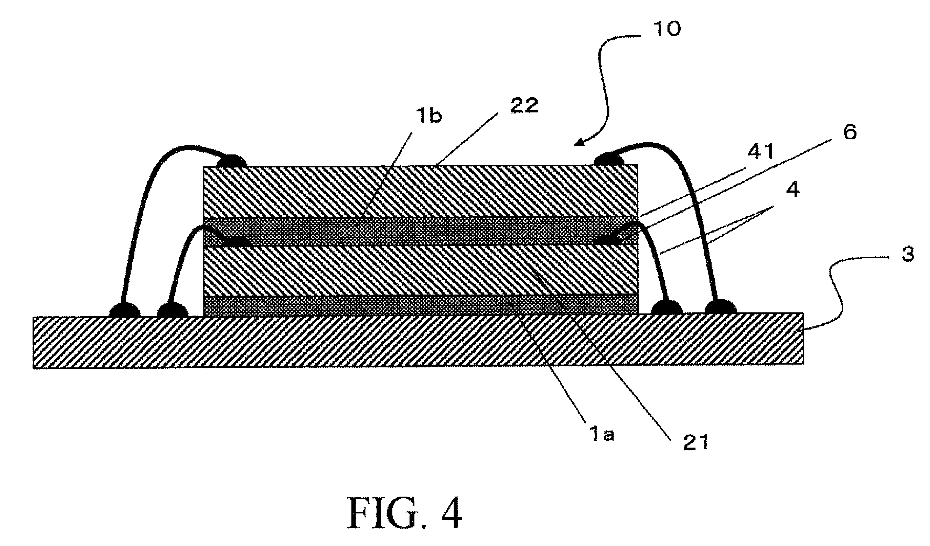

Further, the adhesive film 1 of the present invention can be appropriately used for a semiconductor device in which semiconductor elements are laminated together in a multistep manner as shown in FIG. 4.
In this case, an area in a planar view of a first semiconductor element 21 located on a lower side may be substantially equal to that of a second semiconductor element 22 located on an upper side, or the area in the planar view of the first semiconductor element 21 may be smaller than that of the second semiconductor element 22.
In the semiconductor device shown in FIG. 4, the area in the planar view of the first semiconductor element 21 is substantially equal to that of the second semiconductor element 22.
As shown in FIG. 4, in the semiconductor device 10, an adhesive film 1a, the first semiconductor element 21, an adhesive film 1b and the second semiconductor element 22 are laminated together on a side of one surface (an upper side in FIG. 4) of the substrate 3 in this order.
Terminals 6 formed on a functional surface of the first semiconductor element 21 are electrically connected to the one surface of the substrate 3 via bonding wires 4. In this structure, a portion 41 of each of the bonding wires 4 near the terminals 6 is passed through the adhesive film 1b.
Such an adhesive film 1b is formed of the above mentioned resin composition including the epoxy resin, the acrylic resin, and the acrylic oligomer having the weight average molecular weight of 6,000 or less. In the case where the amount of the acrylic resin contained in the resin composition is defined as the Wa and the amount of the acrylic oligomer contained therein is defined as the Wb, the ratio of the Wa/Wb is in the range of 0.5 to 4.
Further, the adhesive film 1a may be the same as the adhesive film 1b or different from it.

Since the adhesive film 1b is formed of the resin composition having the above mentioned composition, it can have excellent flowability when being heated.
Therefore, even if the portion 41 of each of the bonding wires 4 near the terminals 6 is passed through the adhesive film 1b it is possible to prevent occurrence of deformation or disconnection of the bonding wires 4. As a result, the bonding wires 4 can reliably connect between the terminals 6 of the first semiconductor element 21 and the one surface of the substrate 3.
Further, since the adhesive film 1b has low average linear expansion, it can be cured by heating without occurrence of damage of the bonding wires 4.

FIG. 4 shows a case that the area in the planar view of the first semiconductor element 21 is substantially equal to that of the second semiconductor element 22, but it is not limited thereto. The area in the planar view of the first semiconductor element 21 may be smaller than that of the second semiconductor element 22.

Further, the substrate 3 and the first semiconductor element 21 may be bonded together using an adhesive film having the same composition as the above mentioned adhesive film 1b or using an adhesive agent in the form of paste or the like.
Furthermore, it is preferred that the first semiconductor element 21 and the second semiconductor element 22 are sealed with a sealing material or the like.

### EXAMPLES

Next, description will be made on a number of concrete examples of the present invention, but the present invention is not limited thereto.

### (Example 1)

### <Manufacture of Adhesive Film>

19.67 wt% of an orthocresol novolac type epoxy resin having an epoxy equivalent of 200 g/eq ("EOCN-1020-80", produced by Nippon Kayaku Co., Ltd.) and 29.47 wt% of a trifunctional epoxy resin having an epoxy equivalent of 200 g/eq ("NC6000", produced by Nippon Kayaku Co., Ltd.) as epoxy resins; 9.98 wt% of an acryl ester copolymer (an ethyl acrylate-butyl acrylate-acrylonitrile-acrylic acid-hydroxy ethyl methacrylate copolymer) having a glass transition temperature of 6°C and a weight average molecular weight of 800,000 ("SG-708-6DR", produced by Nagase ChemteX Corporation) as an acrylic resin; 9.98 wt% of an acrylic oligomer having a glass transition temperature of -57°C, a weight average molecular weight of 2,900 and being in the form of liquid at room temperature ("UG-4010", produced by TOAGOSEI CO., LTD.); 18.43 wt% of a liquid phenol compound having a hydroxyl equivalent of 141 g/OH group ("MEH-8000H", produced by MEIWA PLASTIC INDUSTRTES, LTD.) and 12.31 wt% of a solid phenol resin having a hydroxyl equivalent of 104 g/OH group ("PR-HF-3", produced by SUMITOMO BAKELITE Co., Ltd.) as curing agents; 0.13 wt% of an imidazole compound having a melting point of 195°C ("2P4MHZ-PW", produced by SHIKOKU CHEMICALS CORPORATION) as a curing catalyst; and 0.03 wt% of γ-glycidoxy propyl trimethoxy silane ("KBM403E", produced by Shin-Etsu Chemical Co. Ltd.) as a coupling agent were dissolved into methyl ethyl ketone (MEK) to obtain a resin varnish having a resin solid content of 59%.

Next, the above mentioned resin varnish was applied onto a polyethylene terephthalate film having a thickness of 50 µm ("MRX50 (product number)", produced by Mitsubishi Chemical Corporation), and then dried at 90°C for 5 minutes to thereby obtain an adhesive film having a thickness of 25 µm.
In this regard, it is to be noted that a melting viscosity at 100°C of the obtained adhesive film was 54 Pa·s.
Further, elastic modulus at 175°C of a cured product, which was obtained by subjecting the adhesive film to a heat treatment at 175°C for 2 hours, was 32 MPa.

On the other hand, Clear Tec CT-H717 (produced by KURARAY CO., LTD.) was casted using an extruder to form a base film having a thickness of 100 µm, and then a surface of the base film was subjected to a corona treatment.
Next, 50 parts by weight of 2-ethyl hexyl acrylate, 10 parts by weight of butyl acrylate, 37 parts by weight of vinyl acetate and 3 parts by weight of 2-hydroxy ethyl methacrylate were copolymerized to obtain a copolymer having a weight average molecular weight of 500,000.
The copolymer was applied onto a polyester film (corresponding to a cover film of a coherent film) subjected to a release treatment and having a thickness of 38 µm so as to become a thickness of 10 µm after being dried, and then dried at 80°C for 5 minutes to obtain a coherent layer.
Thereafter, this coherent layer was laminated onto the surface subjected to the corona treatment of the base film to thereby obtain the coherent film.
Next, the above mentioned adhesive film was half cut so as to allow a portion to which a wafer is bonded to remain, the cover film of the coherent film was removed from the coherent layer, and the cut adhesive film attached to the coherent layer to thereby obtain a die attach film having a dicing sheet function.

### <Manufacture of Semiconductor Device>

The polyethylene terephthalate film of the die attach film having a dicing sheet function was removed from the adhesive film, and then the adhesive film was bonded to a rear surface of a silicon wafer having a diameter of 5 inches and a thickness of 200 µm at a temperature of 40°C and a pressure of 0.3 MPa to thereby obtain the wafer with the die attach film having the dicing sheet function.
Thereafter, this wafer was diced (cut) using a dicing saw at a rotation rate of 30,000 rpm and cutting rate of 50 mm/sec to thereby obtain semiconductor elements each having a size of 5 mm × 5 mm.
Next, the semiconductor elements were pushed up from a rear surface of the die attach film having the dicing sheet function so as to separate between the adhesive film and the coherent layer to thereby obtain the semiconductor elements each having the adhesive film (adhesive layer).
The semiconductor element having the adhesive film was compressed onto a bismaleimide-triazine resin substrate (circuit steps having sizes of 5 to 10 µm) coated with a solder resist ("AUS308 (product name)", produced by TAIYO INK MFG. CO., LTD.) at 130°C and 5 N for 1.0 second so that the semiconductor element was die-bonded to the substrate through the adhesive film, and then the adhesive film was subjected to a heat treatment at 120°C for 1 hour to thereby provisionally cure it.
Thereafter, the semiconductor element was sealed with a sealing resin ("EME-G760"), and then the same was subjected to a heat treatment at 175°C for 2 hours so that the sealing resin was cured to thereby obtain a semiconductor device.
In this regard, it is to be noted that 9 semiconductor devices were further manufactured in the same manner as described above to thereby obtain 10 semiconductor devices in total.

### (Example 2)

10 semiconductor devices were manufactured in the same manner as in the Example 1 except that the following acrylic oligomer was used.
An acrylic oligomer having a glass transition temperature of 60°C, a weight average molecular weight of 4,600 and being in the form of solid at room temperature ("UG-3900", produced by TOAGOSEI CO., LTD.) was used.
In this regard, it is to be noted that a melting viscosity at 100°C of the obtained adhesive film was 65 Pa·s.
Further, elastic modulus at 175°C of a cured product, which was obtained by subjecting the adhesive film to a heat treatment at 175°C for 2 hours, was 31 MPa.

### (Example 3)

10 semiconductor devices were manufactured in the same manner as in the Example 1 except that the amounts of the acrylic resin and the acrylic oligomer were changed as follows.
7.48 wt% of the acryl ester copolymer (the ethyl acrylate-butyl acrylate-acrylonitrile-acrylic acid-hydroxy ethyl methacrylate copolymer) having the glass transition temperature of 6°C and the weight average molecular weight of 800, 000 ("SG-708-6DR", produced by Nagase ChemteX Corporation) as the acrylic resin, and 12.48 wt% of the acrylic oligomer having the glass transition temperature of -57°C, the weight average molecular weight of 2,900 and being in the form of liquid at room temperature ("UG-4010", produced by TOAGOSEI CO., LTD.) were used.
In this regard, it is to be noted that a melting viscosity at 100°C of the obtained adhesive film was 36 Pa·s.
Further, elastic modulus at 1.756°C of a cured product, which was obtained by subjecting the adhesive film to a heat treatment at 175°C for 2 hours, was 30 MPa.

### (Example 4)

10 semiconductor devices were manufactured in the same manner as in the Example 1 except that the amounts of the acrylic resin and the acrylic oligomer were changed as follows.
13.31 wt% of the acryl ester copolymer (the ethyl acrylate-butyl acrylate-acrylonitrile-acrylic acid-hydroxy ethyl methacrylate copolymer) having the glass transition temperature of 6°C and the weight average molecular weight of 800,000 ("SG-708-6DR", produced by Nagase ChemteX Corporation) as the acrylic resin, and 6.65 wt% of the acrylic oligomer having the glass transition temperature of -57°C, the weight average molecular weight of 2,900 and being in the form of liquid at room temperature ("UG-4010", produced by TOAGOSEI CO., LTD.) were used.
In this regard, it is to be noted that a melting viscosity at 100°C of the obtained adhesive film was 102 Pa·s.
Further, elastic modulus at 175°C of a cured product, which was obtained by subjecting the adhesive film to a heat treatment at 175°C for 2 hours, was 21 MPa.

### (Example 5)

10 semiconductor devices were manufactured in the same manner as in the Example 1, except that the following acrylic oligomer was used.
An acrylic oligomer having a glass transition temperature of -77°C and a weight average molecular weight of 3,000 ("UP-1000", produced by TOAGOSEI CO., LTD.) was used.
In this regard, it is to be noted that a melting viscosity at 100°C of the obtained adhesive film was 52 Pa·s.
Further, elastic modulus at 1.756°C of a cured product, which was obtained by subjecting the adhesive film to a heat treatment at 175°C for 2 hours, was 12 MPa.

### (Example 6)

10 semiconductor devices were manufactured in the same manner as in the Example 1 except that the following acrylic resin was used.
An acryl ester copolymer (an butyl acrylate-acrylonitrile-ethyl acrylate copolymer) having a glass transition temperature of 15°C and a weight average molecular weight of 850,000 ("SG-PZ-DR", produced by Nagase ChemteX Corporation) was used as the acrylic resin.
In this regard, it is to be noted that a melting viscosity at 100°C of the obtained adhesive film was 58 Pa·s.
Further, elastic modulus at 175°C of a cured product, which was obtained by subjecting the adhesive film to a heat treatment at 175°C for 2 hours, was 27 MPa.

### (Comparative Example 1)

10 semiconductor devices were manufactured in the same manner as in the Example 1 except that the following acrylic oligomer was used.
An acrylic oligomer having a glass transition temperature of 85°C and a weight average molecular weight of 8,500 ("UC-3910", produced by TOAGOSEI CO., LTD.) was used.
In this regard, it is to be noted that a melting viscosity at 100°C of the obtained adhesive film was 143 Pa·s.
Further, elastic modulus at 175°C of a cured product, which was obtained by subjecting the adhesive film to a heat treatment at 175°C for 2 hours, was 26 MPa.

### (Comparative Example 2)

10 semiconductor devices were manufactured in the same manner as in the Example 1 except that the amounts of the acrylic resin and the acrylic oligomer were changed as follows.
2.00 wt% of the acryl ester copolymer (the ethyl acrylate-butyl acrylate-acrylonitrile-acrylic acid-hydroxy ethyl methacrylate copolymer) having the glass transition temperature of 6°C and the weight average molecular weight of 800,000 ("SG-708-6DR", produced by Nagase ChemteX Corporation) as the acrylic resin, and 17.96 wt% of the acrylic oligomer having the glass transition temperature of -57°C, the weight average molecular weight of 2,900 and being in the form of liquid at room temperature ("UG-4010", produced by TOAGOSEI CO. , LTD.) were used.
In this regard, it is to be noted that a melting viscosity at 100°C of the obtained adhesive film was 10 Pa·s.
Further, elastic modulus at 175°C of a cured product, which was obtained by subjecting the adhesive film to a heat treatment at 175°C for 2 hours, was 4.7 MPa.

### (Comparative Example 3)

10 semiconductor devices were manufactured in the same manner as in the Example 1 except that the amounts of the acrylic resin and the acrylic oligomer were changed as follows.
18.96 wt% of the acryl ester copolymer (the ethyl acrylate-butyl acrylate-acrylonitrile-acrylic acid-hydroxy ethyl methacrylate copolymer) having the glass transition temperature of 6°C and the weight average molecular weight of 800,000 ("SG-708-6DR", produced by Nagase ChemteX Corporation) as the acrylic resin, and 1.00 wt% of the acrylic oligomer having the glass transition temperature of -57°C, the weight average molecular weight of 2,900 and being in the form of liquid at room temperature ("UG-4010", produced by TOAGOSEI CO., LTD.) were used.
In this regard, it is to be noted that a melting viscosity at 100°C of the obtained adhesive film was 192 Pa·s.
Further, elastic modulus at 175°C of a cured product, which was obtained by subjecting the adhesive film to a heat treatment at 175°C for 2 hours, was 17 MPa.

The following evaluations were carried out for each of the semiconductor devices obtained in the Examples 1 to 6 and the Comparative Examples 1 to 3. Obtained results are shown in Table 1 together with evaluation items.

### 1. Initial Filling Property

An initial filling property (a circuit fill ability) was evaluated by checking each of the semiconductor devices obtained in the Examples 1 to 6 and the Comparative Examples 1 to 3 before being sealed using a scanning acoustic tester (SAT), and then calculating a filling percentage that the adhesive film was filled into the circuit steps provided on the resin substrate. The symbols in Table 1 are defined as follows.
A: The filling percentage was 90% or more (including 100%).
B: The filling percentage was 80% or more, but less than 90%.
C: The filling percentage was 40% or more, but less than 80%.
D: The filling percentage was less than 40%.

### 2. Storage Stability

Storage stability of each of the semiconductor devices obtained in the Examples 1 to 6 and the Comparative Examples 1 to 3 was evaluated by subjecting it to a storage treatment at 50°C for 1 day as an acceleration test, measuring a curing heat value thereof, and then calculating a percentage of the curing heat value (mJ/mg) after being cured with respect to an initial curing heat value (mJ/mg). An unit was "%". The nearer this value is 100 %, the higher the storage stability shows. The storage stability was measured using a differential scanning calorimeter (DSC).
A: The percentage of the curing heat value after being cured with respect to the initial curing heat value was 90% or more.
B: The percentage of the curing heat value after being cured with respect to the initial curing heat value was 70% or more, but less than 90%.
C: The percentage of the curing heat value after being cured with respect to the initial curing heat value was 50% or more, but less than 70%.
D: The percentage of the curing heat value after being cured with respect to the initial curing heat value was less than 50%.

### 3. Heat Resistance

Heat resistance of each of the adhesive film obtained in the Examples 1 to 6 and the Comparative Examples 1 to 3 was evaluated by measuring a glass transition temperature (Tg) thereof after being cured using a thermomechanical analyser (TMA).

### 4. Adhesion at Low Temperature

Adhesion at low temperature of each of the adhesive film obtained in the Examples 1 to 6 and the Comparative Examples 1 to 3 was evaluated by attaching it to a rear surface of a wafer having a thickness of 550 µm at a temperature of 40°C and a pressure of 0.3 MPa, and then measuring 180° peel strength thereof.
A: The peel strength was 100 N/m or more.
B: The peel strength was 50 N/m or more, but less than 100 N/m.
C: The peel strength was 30 N/m or more, but less than 50 N/m.
D: The peel strength was less than 30 N/m.

### 5. Existence or Non-existence of Penetration or the like of Filler

In the Examples 1 to 6 and the Comparative Examples 1 to 3, after the semiconductor elements and the bonding wires were sealed with the sealing resin to thereby obtain the semiconductor devices, whether or not the filler penetrated into the adhesive films was checked by observing cross-sections of the semiconductor devices using a microscope. The symbols in Table 1 are defined as follows.
A: The filler hardly penetrated into the adhesive films.
B: The filler penetrated into the adhesive films, and breakage or the like occured in a part of the semiconductor elements.

Table 1

**Table 1**

| | | Ex. 1 | Ex. 2 | Ex. 3 | Ex. 4 | Ex. 5 | Ex. 6 | Com. Ex. 1 | Com. Ex. 2 | Com. Ex. 3 |
|---|---|---|---|---|---|---|---|---|---|---|
| Epoxy Resin | EOCN-1020-80 | 19.67 | 19.67 | 19.67 | 19.67 | 19.67 | 19.67 | 19.67 | 19.67 | 19.67 |
| | NC6000 | 29.47 | 29.47 | 29.47 | 29.47 | 29.47 | 29.47 | 29.47 | 29.47 | 29.47 |
| Acrylic Resin | SG-708-6DR | 9.98 | 9.98 | 7.48 | 13.31 | 9.98 | | 9.98 | 2.00 | 18.96 |
| | SG-PZ-DR | | | | | | 9.98 | | | |
| Acrylic Oligomer | UG-4010 | 9.98 | | 12.48 | 6.65 | | 9.98 | | 17.96 | 1.00 |
| | UG-3900 | | 9.98 | | | | | | | |
| | UP-1000 | | | | | 9.98 | | | | |
| | UC-3910 | | | | | | | 9.98 | | |
| Curing Agent | MEH-8000H | 18.43 | 18.43 | 18.43 | 18.43 | 18.43 | 18.43 | 18.43 | 18.43 | 18.43 |
| | PR-HE-3 | 12.31 | 12.31 | 12.31 | 12.31 | 12.31 | 12.31 | 12.31 | 12.31 | 12.31 |
| Curing Catalyst | 2P4MHZ-PW | 0.13 | 0.13 | 0.13 | 0.13 | 0.13 | 0.13 | 0.13 | 0.13 | 0.13 |
| Coupling Agent | KBM403E | 0.03 | 0.03 | 0.03 | 0.03 | 0.03 | 0.03 | 0.03 | 0.03 | 0.03 |
| Acrylic Resin/Acrylic Oligomer (Wa/Wb) | | 1 | 1 | 0.6 | 2 | 1 | 1 | 1 | 0.1 | 19 |
| Melting Viscosity at 100°C of Adhesive Film [Pa·s] | | 54 | 65 | 36 | 102 | 52 | 58 | 143 | 10 | 192 |
| Elastic Modulus at 175°C of Cured Product of Adhesive film [MPa] | | 32 | 31 | 30 | 21 | 12 | 27 | 26 | 4.7 | 17 |
| Evaluations | | | | | | | | | | |
| Initial Filling Property | | A | B | A | B | A | A | D | A | D |
| Storage Stability | | A | A | A | A | A | A | A | A | A |
| Heat Resistance | | 170 | 168 | 165 | 165 | 151 | 168 | 169 | 141 | 154 |
| Adhesion at Low Temperature | | A | A | A | A | B | B | A | A | A |
| Existence or Non-existence of Penetration or the like of Filler | | A | A | A | A | A | A | A | B | A |

As can be seen from Table 1, each of the adhesive films obtained in the Examples 1 to 6 has an excellent initial filling property.
Further, each of the adhesive films obtained in the Examples 1 to 6 has excellent heat resistance and superior adhesion at low temperature.
In addition, in the adhesive devices obtained in the Examples 1 to 6, the filler hardly penetrated into the adhesive films thereof.

### INDUSTRIAL APPLICABILITY

According to the present invention, the adhesive film which can be softened by heating in the bonding step and has the improved filling property for the irregularities of the substrate, and the semiconductor device having the above adhesive film can be provided. Thus, the adhesive film and the semiconductor device of the present invention have industrial applicability.

## Claims

1. An adhesive film being adapted to be used for bonding a semiconductor element and a substrate together or bonding semiconductor elements together, the adhesive film being formed of a resin composition, the resin composition comprising:
an epoxy resin;
an acrylic resin; and
an acrylic oligomer having a weight average molecular weight of 6,000 or less,
wherein in the case where an amount of the acrylic resin contained in the resin composition is defined as Wa and an amount of the acrylic oligomer contained therein is defined as Wb, a ratio of Wa/Wb is in the range of 0.5 to 4.

2. The adhesive film as claimed in claim 1, wherein a glass transition temperature of the acrylic oligomer is -30°C or lower.

3. The adhesive film as claimed in claim 1, wherein the amount of the acrylic oligomer with respect to a total amount of the resin composition is in the range of 5 to 30 wt%.

4. The adhesive film as claimed in claim 1, wherein the acrylic oligomer includes at least one of a carboxyl group and a glycidyl group.

5. The adhesive film as claimed in claim 1, wherein the acrylic oligomer is in the form of liquid at room temperature.

6. The adhesive film as claimed in claim 1, wherein the resin composition further comprises a curing agent.

7. The adhesive film as claimed in claim 6, wherein the curing agent includes a liquid phenol compound.

8. The adhesive film as claimed in claim 1, wherein the resin composition further comprises a curing catalyst.

9. The adhesive film as claimed in claim 8, wherein the curing catalyst includes an imidazole compound.

10. The adhesive film as claimed in claim 8, wherein a melting point of the curing catalyst is 150°C or higher.

11. The adhesive film as claimed in claim 1, wherein a melting viscosity at 100°C of the adhesive film is 80 Pa·s or less.

12. The adhesive film as claimed in claim 1, wherein elastic modulus at 175°C of a cured product, which is obtained by subjecting the adhesive film to a heat treatment at 175°C for 2 hours, is 30 MPa or more.

13. An adhesive film being adapted to be used as an adhesive layer included in a semiconductor device, the semiconductor device in which a first semiconductor element having a functional surface, the adhesive layer and a second semiconductor element are laminated together on a side of one surface of a substrate in this order, wherein terminals formed on the functional surface of the first semiconductor element are electrically connected to the one surface of the substrate via bonding wires, a portion of each of the bonding wires near the terminals passing through the adhesive layer, the adhesive film being formed of a resin composition, the resin composition comprising:
an epoxy resin;
an acrylic resin; and
an acrylic oligomer having a weight average molecular weight of 6,000 or less,
wherein in the case where an amount of the acrylic resin contained in the resin composition is defined as Wa and an amount of the acrylic oligomer contained therein is defined as Wb, a ratio of Wa/Wb is in the range of 0.5 to 4.

14. The adhesive film as claimed in claim 13, wherein an area in a planar view of the second semiconductor element is substantially equal to that of the first semiconductor element.

15. The adhesive film as claimed in claim 13, wherein an area in a planar view of the second semiconductor element is lager than that of the first semiconductor element.

16. A semiconductor device in which a semiconductor element and a substrate or semiconductor elements are bonded together using the adhesive film defined by claim 1.
